# EUROPÄISCHE PATENTSCHRIFT

(11) **EP 2 406 886 B1**
(45) Veröffentlichungstag und Bekanntmachung des Hinweises auf die Patenterteilung: **19.06.2013**
(21) Anmeldenummer: 10705100.5
(22) Anmeldetag: 11.02.2010
(51) Int. Cl.: H03M 1/18

(54) **VORRICHTUNG ZUM ANALOG-DIGITAL-WANDELN VON SIGNALEN IN EINEM GROSSEN DYNAMIKBEREICH**
DEVICE FOR CONVERTING HIGH DYNAMIC RANGE ANALOG SIGNALS TO DIGITAL
DISPOSITIF POUR CONVERTIR DES SIGNAUX ANALOGIQUES À PLAGE DYNAMIQUE ÉLEVÉE EN SIGNAUX NUMÉRIQUES

(30) Priorität: 11.03.2009 DE 102009012562
(43) Veröffentlichungstag der Anmeldung: 18.01.2012
(73) Patentinhaber: Rohde & Schwarz GmbH & Co. KG, 81671 München (DE)
(72) Erfinder: HISCH, Martin, 85661 Fortsinning (DE)
(74) Vertreter: Beder, Jens
(86) Internationale Anmeldenummer: PCT/EP2010/000859
(87) Internationale Veröffentlichungsnummer: WO 2010/102703

(56) Entgegenhaltungen:
- EP-A2- 0 351 788
- US-B1- 7 053 804

## Beschreibung

Die Erfindung betrifft eine Vorrichtung zur Erweiterung des Dynamikbereichs bei Breitband-Analog-Digital-Wandler.

Der Einsatz breitbandiger Analog-Digital-Wandler ermöglichte die Entwicklung moderner breitbandiger Kommunikationsverfahren. Mit der Bandbreite des Kommunikationsverfahrens wächst jedoch auch die Anforderung an die Dynamik der Analog-Digital-Wandler z.B. in einer Empfangsvorrichtung. Der Stand der Technik löst das Dynamikproblem mit einem Vorverstärker mit einem variablem Verstärkungsfaktor und einem nachgeschalteten Analog-Digital-Wandler. Ein Regelalgorithmus sorgt dabei für eine angepasste Einstellung des Verstärkungsfaktors und aus den digitalen Abtastwerten wird dabei häufig die Ist-Aussteuerung abgeleitet.

Ein solches Verfahren hat aber eine Reihe von Nachteilen. Die Veränderung der analogen Verstärkung verursacht Störimpulse. Für amplitudensensitive Anwendungen ist die Zuordnung der digitalen Signal-Abtastwerte zur entsprechenden analogen Verstärkung sehr wichtig und kann aufgrund der Variation der analogen Verstärkung nur sehr schwer verwirklicht werden, wenn dies überhaupt möglich ist. Impulsstörungen führen zu einer kurzzeitigen Übersteuerung des Analog-Digital-Wandlers und führen nach dem Regelvorgang für eine einstellbare Haltezeit zu einer Reduzierung der Empfindlichkeit. Nach jedem Regelvorgang muss der komplette nachfolgende Signalzug, sowohl der analoge als auch der digitale Teil, neu einschwingen, was unter Umständen zur deutlichen Verminderung der Messgeschwindigkeit führt.

Die WO 03/009478 A3 offenbart eine alternative Dynamikerweiterung von Analog-Digital-Wandlern. Ein analoger Signalteiler teilt das zu wandelnde Signal in N Signalteile auf. In jedem Signalzweig wird ein unabhängiges Dithersignal, das später wieder entfernt wird, zu dem Signal hinzugefügt und das Signal darauffolgend von einem Analog-Digital-Wandler digitalisiert. Die digitalen Abtastwerte jedes Signalzweigs durchlaufen einen Entzerrer, der die Fehler in Bezug auf Phase und Amplitude beseitigt. Alle Kanäle werden aufsummiert und noch einmal entzerrt. Nachteilig an diesem Verfahren ist, dass bei jeder Verdoppelung der Anzahl der Analog-Digital-Wandler gerade 3 dB Dynamikverbesserung erzielt werden. Um also eine Verbesserung der Dynamik um 12 dB zu erreichen werden 16 Analog-Digital-Wandler benötigt. Dies ist unwirtschaftlich und erfordert eine hohe Genauigkeit in der Abstimmung der vielen Signalzweige aufeinander. Bei sehr breitbandigen Anwendungen kann es unter Umständen zu Problemen bei der Entfernung der Dithersignale kommen, da eine einfache Filterung aufgrund der hohen Bandbreite nicht durchführbar ist. Der Pegel der Dithersignale muss zudem deutlich höher sein als der Pegel des dem Nutzsignal anhaftenden Rauschens, da dieses Rauschen bei allen Kanälen gleich ist, also korreliert. Zum Einstellen der Entzerrer wird weiterhin ein Kalibriervorgang benötigt.

Eine weitere Vorrichtung zum Digitalisieren von Daten ist aus der EP 0 351 788 A2 bekannt. Die Vorrichtung umfasst eine Teilungsrichtung zum Teilen eines analogen Eingangssignals. Dann erweist die Vorrichtung einen ersten Signalzweig und einen zweiten Signalzweig zur Aufnahme des geteilten Signals auf. Der Ausgang des ersten Signalzweigs ist mit einem ersten analogen Digitalwandler verbunden und der Ausgang des zweiten Signalzweigs mit einem zweiten analogen Digitalwandler. Ferner ist eine Schaltvorrichtung vorgesehen, die den ersten oder den zweiten Signalzweig mit einem Signalausgang der Vorrichtung verbindet. Mittels einer Regelvorrichtung, die zwischen dem zweiten Analogwandler und der Schaltvorrichtung angeordnet ist, wird die Amblitute zumindest des Signalteils in dem zweiten Signalzweig an die des ersten Signalzweigs angepasst.

Die Aufgabe der Erfindung ist es, die Probleme des Stands der Technik zu beheben. Vor allem soll eine einfache und wirtschaftliche Vorrichtung zum Digitalisieren von Daten gefunden werden, die einen großen Dynamikbereich aufweist. Diese Vorrichtung soll durch die Dynamikvergrößerung keine oder nur geringe Störungen erzeugen.

Die Aufgabe ist durch die erfindungsgemäße Vorrichtung nach Anspruch 1 gelöst. Die Vorrichtung weist dabei eine Teilungsvorrichtung mit einem ersten und zweiten Ausgang auf, wobei die Teilungsvorrichtung z.B. ein Leistungsteiler ist, der ein analoges Eingangssignal in ein erstes an den ersten Ausgang ausgebbares analoges Signal eines ersten Signalzweigs mit einem ersten Leistungsbruchteil und in ein zweites an einen zweiten Ausgang ausgebbares analoges Signal eines zweiten Signalzweigs mit einem zweiten Leistungsbruchteil aufteilt. Des Weiteren sind der erste und der zweite Ausgang des Leistungsteilers jeweils mit einem ersten und zweiten Analog-Digital-Wandler verbunden, so dass das erste und zweite analoge Signal jeweils digitalisiert werden können. Eine Schaltvorrichtung verbindet entweder den ersten oder den zweiten Signalzweig mit einem Signalausgang. Eine Regelvorrichtung ist zwischen dem zweiten Analog-Digital-Wandler und der Schaltvorrichtung zum adaptiven Anpassen zumindest der Amplituden des zweiten digitalen Ausgangssignals des zweiten Analog-Digital-Wandlers an die Amplituden des ersten digitalen Ausgangssignals des ersten Analog-Digital-Wandlers angeordnet.

Durch die Anpassung zumindest der Amplituden des zweiten Signalzweigs in der Regelvorrichtung an die Amplituden des ersten Signalzweigs, wird bei einer Umschaltung vom ersten auf den zweiten Signalzweig, z.B. bei Übersteuerung des ersten Analog-Digital-Wandlers, keine Störung aufgrund unterschiedlicher Amplituden erzeugt. Durch eine solche automatische Anpassung entfallen auch eventuelle Kalibriervorgänge.

Die Unteransprüche betreffen vorteilhafte Weiterführungen der erfindungsgemäßen Vorrichtung.

Es ist vorteilhaft, dass, wenn die Schaltvorrichtung den ersten Signalzweig mit dem Signalausgang verbindet, die Regelvorrichtung die Amplituden adaptiv anpasst und, wenn die Schaltvorrichtung den zweiten Signalzweig mit dem Signalausgang verbindet, die Regelvorrichtung die Amplituden des zweiten digitalen Ausgangssignals entsprechend der bei der vorherigen Schaltstellung zuletzt angepassten Amplituden regelt. Dadurch wird vermieden, dass beim Umschalten auf den zweiten Signalzweig bei einer Übersteuerung des ersten Analog-Digital-Wandlers weiterhin die Amplituden des zweiten Signalzweigs an die Amplituden des übersteuerten Signalzweigs angepasst werden.

Es ist weiterhin vorteilhaft, dass die Regelvorrichtung ein adaptives Filter ist und zur Anpassung der Amplitude und der Phase die Filterkoeffizienten zyklisch an ein an einen Referenzeingang angelegtes Referenzsignal anpassbar sind. Durch das adaptive Filter können sowohl Amplituden als auch Phasen des zweiten Signalzweigs angepasst werden und ein Phasenfehler beim Umschalten vom ersten auf den zweiten Signalzweig wird vermieden. Ist die Anpassung der Filterkoeffizienten weiterhin abschaltbar, können nach dem Umschalten von dem ersten auf den zweiten Signalzweig die Filterkoeffizienten festgehalten werden ohne von dem übersteuerten ersten Signalzweig verfälscht zu werden.

Es ist zusätzlich vorteilhaft, dass der erste Signalzweig zwischen dem ersten Analog-Digital-Wandler und der Schaltvorrichtung eine Referenzverbindung zu der Regelvorrichtung aufweist und dem ersten Analog-Digital-Wandler und der Referenzverbindung zu der Regelvorrichtung eine Verzögerungsschaltung angebracht ist. Durch die Verzögerungsschaltung im ersten Signalzweig wird die Verarbeitungsdauer des ersten Signalzweigs an die des zweiten Signalzweiges mit dem zusätzlichen adaptiven Filter, insbesondere durch Berücksichtigung der Filterlaufzeit, angepasst. Durch die Verzögerung des Referenzsignals für die Regelvorrichtung kann bei einer Übersteuerung des ersten Analog-Digital-Wandlers die Anpassung der Amplituden bzw. der Filterkoeffizienten der Regelvorrichtung abgeschaltet und die Filterkoeffizienten eingefroren werden, bevor ein übersteuertes Referenzsignal an der Regelvorrichtung ankommt.

Es ist auch vorteilhaft, dass die erfindungsgemäße Vorrichtung eine Steuervorrichtung mit einem Signaleingang zum Empfang eines Steuersignals, welches die Übersteuerung des ersten Analog-Digital-Wandlers beschreibt, und mit einem Signalausgang zum Ausgeben eines Schaltsignals, aufweist. Der Signalausgang der Steuervorrichtung ist vorteilhaft mit einem Steuereingang der Schaltvorrichtung verbunden. Dadurch kann bei einer Übersteuerung des ersten Analog-Digital-Wandlers automatisch von dem ersten auf den zweiten Signalzweig umgeschaltet werden. Der Signalausgang der Steuervorrichtung ist vorteilhaft auch mit einem Steuereingang der Regelvorrichtung verbunden ist, so dass bei einer Übersteuerung des ersten Analog-Digital-Wandlers automatisch die Anpassung der Amplituden bzw. der Filterkoeffizienten abgeschaltet werden kann.

Das Schaltsignal der Steuervorrichtung wird vorteilhaft nach jedem Empfang einer Steuersignalinformation, welche einem übersteuerten Analog-Digital-Wandler entspricht, für eine Mindestzeit ausgegeben und die Mindestzeit beginnt nach jedem Empfang der Steuersignalinformation wieder von neuem. Dadurch kann das ständige Hin- und Herschalten zwischen den Signalzweigen aufgrund eines Betriebs im Grenzbereich zwischen normalen und übersteuerten ersten Analog-Digital-Wandler vermieden werden.

Es ist vorteilhaft, dass der erste und der zweite Analog-Digital-Wandler gleichen Typs sind und zeitsynchron arbeiten. Dadurch wird eine zeitsynchrone Abtastung gewährleistet und Phasenfehler vermieden. Die mindestens zwei Analog-Digital-Wandler sind hierzu mit einer gemeinsamen Zeitbasisquelle verbunden.

Es ist zusätzlich vorteilhaft, dass der erste Leistungsbruchteil größer als der zweite Leistungsbruchteil ist. Dadurch funktioniert der zweite Analog-Digital-Wandler auch bei übersteuertem ersten Analog-Digital-Wandler noch und der Dynamikbereich der Analog-Digital-Wandlung wird erweitert.

Es ergeben sich weiterhin Vorteile daraus, dass der erste und der zweite Signalzweig jeweils einen digitalen Datenreduzierer aufweisen, vor allem, wenn dieser vor der Regelvorrichtung angeordnet ist. Die Anpassung der Amplituden bzw. der Filterkoeffizienten ist sehr rechenintensiv und kann durch eine Datenreduktion der Signale vereinfacht und beschleunigt werden.

Es ist vorteilhaft, wenigstens einen dritten Signalzweig im Verhältnis zum zweiten Signalzweig aufzubauen, wie den zweiten Signalzweig zum ersten Signalzweig, wobei eine Regelvorrichtung des dritten Signalzweigs zum adaptiven Anpassen zumindest der Amplituden eines dritten digitalen Ausgangssignals eines dritten Analog-Digital-Wandlers an die Amplituden des ersten digitalen Ausgangssignals des ersten Analog-Digital-Wandlers geeignet ist. Durch zusätzliche Signalzweige kann der Dynamikbereich noch weiter ausgebaut werden, da wenn sowohl der erste als auch der zweite Analog-Digital-Wandler übersteuert sind, noch ein dritter nicht übersteuerter Analog-Digital-Wandler bleibt.

Es ist vorteilhaft, dass die Initialisierungswerte der Regelvorrichtung statisch oder mit Hilfe eines Kalibriervorgangs dynamisch vorausberechenbar sind. Eine statische Berechnung der Initialisierungswerte der Regelvorrichtung ist einfach, schnell und ohne Betriebsunterbrechung durchzuführen. Eine Kalibrierung erlaubt eine genauere Festlegung der Initialisierungswerte in Abhängigkeit der Amplituden des analogen Eingangssignals.

Nachfolgend werden verschiedene Ausführungsbeispiele der erfindungsgemäßen Vorrichtung zum Digitalisieren von Daten anhand der Zeichnung beschrieben. Die Zeichnung zeigt:
- Fig. 1: schematische Darstellung eines ersten Ausführungsbeispiels der erfindungsgemäßen Vorrichtung zum Digitalisieren von Daten; und
- Fig. 2: schematische Darstellung eines zweiten Ausführungsbeispiels der erfindungsgemäßen Vorrichtung zum Digitalisieren von Daten.

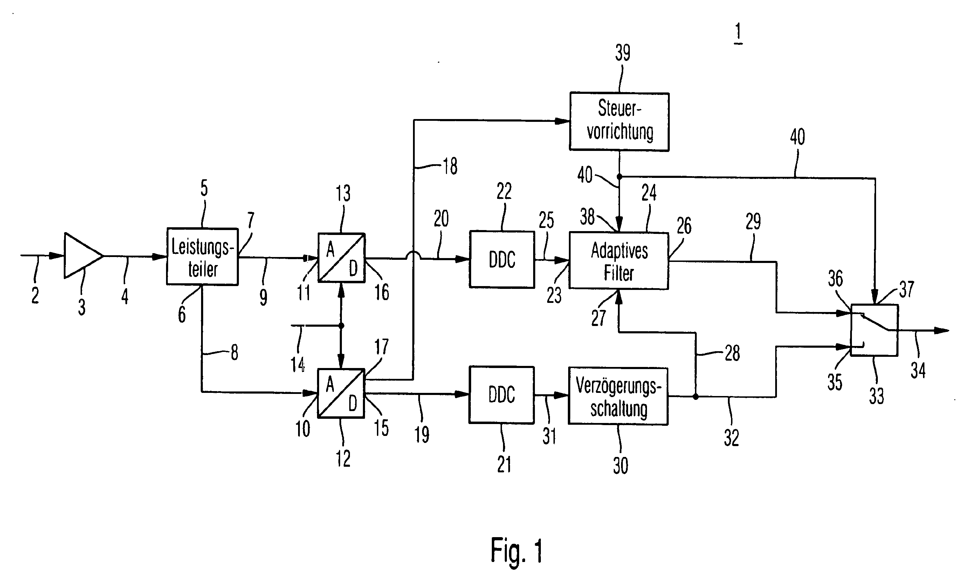

Fig. 1 zeigt eine Schaltung 1 eines ersten Ausführungsbeispiels der erfindungsgemäßen Vorrichtung zum Digitalisieren von Daten. Ein analoges Eingangssignal 2 wird in einem Vorverstärker 3 zu einem verstärkten analogen Eingangssignal 4 verstärkt und einem Leistungsteiler 5 zugeführt. Der Leistungsteiler 5 weist einen ersten und einen zweiten Ausgang 6 und 7 auf, an die das verstärkte analoge Eingangssignal 4 jeweils mit den Leistungsbruchteilen (n-1)/n und 1/n gedämpft gegeben wird. Mit n=16 ergibt sich ein Verhältnis der beiden Leistungsbruchteile von nahezu 12 dB. Der Leistungsteiler 5 gibt also am ersten Ausgang 6 ein erstes analoges Ausgangssignal 8 aus, das dem mit dem Leistungsbruchteil (n-1)/n gedämpften verstärkten analogen Eingangssignal 4 entspricht. Entsprechend gibt der Leistungsteiler 5 am zweiten Ausgang 7 ein zweites analoges Ausgangssignal 9 aus, das dem mit dem Leistungsbruchteil 1/n gedämpften verstärkten analogen Eingangssignal 4 entspricht.

Die beiden Ausgänge 6 und 7 des Leistungsteilers 5 sind jeweils mit einem analogen Eingang 10 und 11 eines ersten bzw. eines zweiten Analog-Digital-Wandlers (ADC; Analog-Digital-Converter) 12 und 13 verbunden. Die beiden Analog-Digital-Wandler 12 und 13 sind vom gleichen Typ und werden von einem Abtasttakt 14 synchronisiert. Dadurch wird sichergestellt, dass die beiden ADCs 12 und 13 zur gleichen Zeit, den gleichen Signalteil des analogen Eingangssignal 2 mit jeweils unterschiedlicher Dämpfung an den Eingängen 10 und 11 empfangen und ebenfalls gleichzeitig die analogen Signalwerte digitalisieren und an die digitalen Ausgänge 15 und 16 geben. Dadurch, dass die beiden analogen Signale 8 und 9 unterschiedlich gedämpft wurden, kann der zweite ADC 13 noch normal arbeiten, auch wenn der erste ADC 12 bereits in einem übersteuerten Zustand ist. Der erste ADC 12 hat einen Steuerausgang 17, an den ein Steuersignal 18 ausgegeben wird, wenn der erste ADC 12 in einem übersteuerten Zustand ist.

Die digitalen Ausgänge 15 und 16 sind jeweils mit einem Eingang eines ersten und zweiten digitalen Datenreduzierers 21 und 22 verbunden. Das erste und das zweite digitalisierte Ausgangssignal 19 und 20 des ersten und des zweiten ADCs 12 und 13 werden jeweils in dem ersten und zweiten digitalen Datenreduzierer 21 und 22 komprimiert.

Der Ausgang des zweiten digitalen Datenreduzierers 22 des zweiten Signalzweigs ist mit einem Signaleingang 23 eines adaptiven Filters 24 als Regelvorrichtung verbunden. Über diese Verbindung erhält das adaptive Filter 24 das zweite reduzierte digitalisierte Ausgangssignal 25. Das adaptive Filter 24 filtert das am Signaleingang 23 anliegende Signal 25 entsprechend der aktuellen Filterkoeffizienten und gibt das gefilterte Signal an den Filterausgang 26. Die Filterkoeffizienten werden entsprechend eines an einem Referenzeingang 27 anliegenden Referenzsignals 28 angepasst, so dass das gefilterte Signal 29 dem Referenzsignal 28 in Phase und Amplitude entspricht. Das Referenzsignal 28 wird aus dem ersten Signalzweig nach einer Verzögerungsschaltung 30 abgezweigt. Das adaptive Filter 24 weist zusätzlich noch einen Steuereingang 38 auf, zum Festhalten der aktuell eingestellten Filterkoeffizienten bei Erhalt eines Steuersignals an dem Steuereingang 38 auf.

Der Ausgang des ersten digitalen Datenreduzierers 21 ist mit einem Eingang einer Verzögerungsschaltung 30 verbunden und das erste reduzierte digitalisierte Ausgangssignal 31 wird in der Verzögerungsschaltung 30 für eine Zeitdauer verzögert, die der Verarbeitungsdauer des adaptiven Filters 24 entspricht, und als verzögertes Signal 32 an den Ausgang der Verzögerungsschaltung 30 gegeben. Da als Referenzsignal 28 für den adaptiven Filter 24 das verzögerte Signal 32 abgezweigt wird und das erste reduzierte digitalisierte Ausgangssignal 31 entsprechend der Laufzeit des adaptiven Filters 24 verzögert wird, sind das gefilterte Signal 29 und das verzögerte Signal 32 phasen- und amplitudengleich.

Über einen Schalter 33 kann nun entweder das verzögerte Signal 32 des ersten Signalzweigs oder das gefilterte Signal 29 des zweiten Signalzweigs mit einem Signalausgang 34 verbunden werden. Der Schalter 33 ist mit einem ersten Signaleingang 35 mit dem Ausgang der Verzögerungsschaltung verbunden und mit einem zweiten Signaleingang 36 mit dem Filterausgang 26 verbunden. Der Schalter 33 weist zusätzlich einen Steuereingang 37 auf, über den die beiden Schaltstellungen gewählt werden können. Da das gefilterte Signal 29 und das verzögerte Signal 32 phasen- und amplitudengleich sind, wird bei einem Umschaltvorgang keine Störung durch den Wechsel vom ersten auf den zweiten Signalzweig entstehen.

Der Steuerausgang 17 des ersten ADCs 12 ist mit einem Eingang einer Steuervorrichtung 39 verbunden. Bei Erhalt eines Steuersignals 18, welches den ersten ADC 12 als übersteuert signalisiert, gibt die Steuervorrichtung 39 für eine eingestellte Zeit ein Schaltsignal 40 an den Ausgang der Steuervorrichtung 39. Der Ausgang der Steuervorrichtung 39 ist mit dem Steuereingang 38 des adaptiven Filters 24 und mit dem Steuereingang 37 des Schalters 33 verbunden. Empfängt die Schaltvorrichtung 33 an ihrem Steuereingang 37 das Schaltsignal 40, so wird der Schalter 33 so geschaltet, dass der zweite Signalzweig mit dem Signalausgang 34 verbunden ist. Gleichzeitig erhält ebenfalls das adaptive Filter 24 am Steuereingang 38 das Schaltsignal 40 und hält die Filterkoeffizienten zeitlich konstant fest, um eine Anpassung der Filterkoeffizienten an einen zeitlichen Verlauf des Referenzsignals 28 mit Störungen eines übersteuerten ADCs 12 zu vermeiden. Aufgrund der Verzögerungsschaltung 30 erreicht das Schaltsignal 40 das adaptive Filter 24 bevor Störungen durch eine Übersteuerung des ADCs 12 im Referenzsignal 28 das adaptive Filter 24 beeinflussen können. Durch die Steuervorrichtung 39 wird bei jedem Erhalt eines Steuersignals 18 eines übersteuerten ADCs 12 eine Schaltsignal 40 für eine bestimmte Zeitdauer ausgegeben. Dadurch wird sichergestellt, dass nach dem Umschalten auf den zweiten Signalzweig zumindest die bestimmte Zeitdauer gewartet wird, bis wieder auf den ersten Signalzweig zurückgeschaltet wird. Sollte in der Zwischenzeit erneut ein Steuersignal 18 eines übersteuerten ADCs 12 erhalten werden, so läuft die bestimmte Zeitdauer wieder von vorne los. Dadurch wird ein ständiges Hin- und Herschalten zwischen dem ersten und dem zweiten Signalzweig im Falle eines Betriebs in der Nähe der Übersteuerung des ersten ADCs 12 vermieden.

Kehrt der erste ADC 12 für eine Zeitdauer, die länger ist als die bestimmte Zeitdauer, wieder in den normalen Betriebsbereich zurück, so werden nach dem Beenden des Schaltsignals 40 die Filterkoeffizienten des adaptiven Filters 24 wieder fortlaufend an das Referenzsignal angepasst.

Die Initialisierungswerte des adaptiven Filters 24 können entweder durch statische Vorausberechnung oder durch eine Kalibrierung dynamisch berechnet werden.

Die Reduzierung der Daten in den digitalen Datenreduzierern 21 und 22 ist dabei nicht beschränkend für die Erfindung. Die Datenreduktion kann ebenfalls entfallen oder an einer anderen Stelle in den beiden Datenzweigen erfolgen oder erst am Signalausgang 34 erfolgen. Allerdings ist es besonders vorteilhaft, die Daten vor dem Eingang des adaptiven Filters 24 zu dezimieren, da die Berechnung der Filterkoeffizienten bei Abtastgeschwindigkeiten von mehr als 200 MSPS sehr rechenintensiv wird und die Rechenlast des adaptiven Filters durch Dezimieren der Daten reduziert werden kann.

Alternativ kann anstatt eines adaptiven Filters 24 auch eine einfache Amplitudenregelung verwendet werden. Dies ist vor allem für phasenunkritische Anwendungen interessant, da eine Amplitudenregelung günstiger und mit weniger Aufwand zu realisieren ist als ein adaptives Filter 24.

Das Steuersignal 18 muss nicht aus dem ADC 12 ausgegeben werden, es kann auch ein digitaler Komparator in den digitalen Teil des ersten Signalzweigs gesetzt werden, der bei Überschreiten einer Schwelle ein Steuersignal 18 ausgibt.

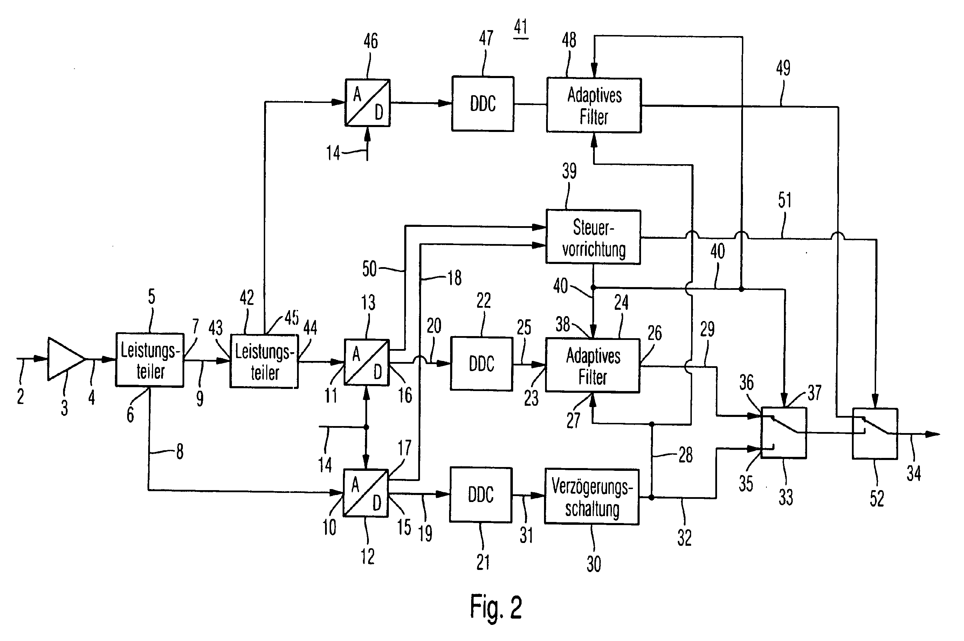

Fig. 2 zeigt eine zweite Schaltung 41 eines zweiten Ausführungsbeispiels der Erfindung. Die Schaltungsteile, die der Schaltung 1 entsprechen werden gleich referenziert und werden nicht noch einmal beschrieben.

Um die Dynamik weiter zu verbessern, wird dem zweiten Signalzweig wiederum ein Leistungsbruchteil (z.B. 12 dB) entnommen und einem dritten Leistungszweig zugeführt. Dazu wird zwischen dem Leistungsteiler 5 und dem zweiten ADC 13 ein zweiter Leistungsteiler 42 angeordnet, wobei nun der zweite Ausgang 7 des Leistungsteilers 5 mit dem Eingang 43 des zweiten Leistungsteilers 42 verbunden ist. Der erste Ausgang 44 des zweiten Leistungsteilers 42 ist der Ausgang mit der geringeren Dämpfung und ist mit dem zweiten ADC 13 verbunden Der zweite Ausgang 45 ist der Ausgang mit der stärkeren Dämpfung von 12 dB und ist mit einem dritten ADC 46 verbunden. Anstatt eines zweiten Leistungsteilers 42 kann auch der Leistungsteiler 5 mit zwei Ausgängen durch einen Leistungsteiler mit drei Ausgängen ersetzt werden. Der dritte ADC 46 digitalisiert das dritte Signal und gibt es zur Datenreduktion an einen digitalen Datenreduzierer 47. Der dritte ADC 46 läuft zeitsynchron zu den ersten beiden und erhält das gleich Taktsignal 14.

Das dezimierte digitalisierte Signal wird in einem zweiten Adaptiven Filter 48 entsprechend dem Referenzsignal 28 gefiltert, so dass das gefilterte Ausgangssignal 49 dem verzögerten Signal 32 in Phase und Amplitude entspricht. Die Filterkoeffizienten des adaptiven Filters 48 werden nur solange angepasst, bis das Schaltsignal 40, welches einen übersteuerten ersten ADC signalisiert, an dem Steuereingang des adaptiven Filters 48 ankommt. Dann werden die Filterkoeffizienten festgehalten, da das Referenzsignal 28 die Fehler des übersteuerten ersten ADCs 12 aufweist.

Ein Schalter 52 verbindet entweder den Ausgang des Schalters 33 oder den dritten Signalzweig mit dem Signalausgang 34. Auch hier ist alternativ zu den Schaltern 33 und 34 ein Schalter mit drei Schaltstellungen möglich.

Übersteuert nun auch der zweite ADC 13, so wird ein zweites Steuersignal 50 an die Steuervorrichtung 39 gegeben, welche ein zweites Schaltsignal 51 für eine bestimmte Zeit an den Schalter 52 gibt. Für die Zeit des Schaltsignals 51 wird der dritte Signalzweig mit dem Signalausgang 34 verbunden.

Die Erfindung ist nicht auf das dargestellte Ausführungsbeispiel beschränkt. Vielmehr sind auch Merkmale der erfindungsgemäßen Vorrichtung zum Digitalisieren von Daten in vorteilhafter Weise kombinierbar. Insbesondere können beide Ausführungsbeispiele nur zwei oder drei oder mehr Zweige aufweisen.

## Patentansprüche

1. Vorrichtung zum Digitalisieren von Daten:
- eine Teilungsvorrichtung (5) zum Teilen eines analogen Eingangssignals (2, 4) in ein erstes an einen ersten Ausgang (6) eines ersten Signalzweigs ausgebbares analoges Signal (8) mit einem ersten Signalteil und ein zweites an einen zweiten Ausgang (7) eines zweiten Signalzweigs mit einem zweiten Signalteil ausgebbares analoges Signal (9);
- einen ersten Analog-Digital-Wandler (12) verbunden mit dem ersten Ausgang (6) der Teilungsvorrichtung (5) zum Digitalisieren des ersten analogen Signals (8);
- einen zweiten Analog-Digital-Wandler (13) verbunden mit dem zweiten Ausgang (7) der Teilungsvorrichtung (5) zum Digitalisieren des zweiten analogen Signals (9);
- einer Schaltvorrichtung (33) zur Verbindung des ersten Signalzweiges oder des zweiten Signalzweiges mit einem Signalausgang (34);
- eine Regelvorrichtung (24) angeordnet zwischen dem zweiten Analog-Digital-Wandler (13) und der Schaltvorrichtung (33) zum adaptiven Anpassen zumindest der Amplituden des zweiten digitalen Ausgangssignals (20) des zweiten Analog-Digital-Wandlers (13) an die Amplituden des ersten digitalen Ausgangssignals (19) des ersten Analog-Digital-Wandlers (12)
**dadurch gekennzeichnet,**
**dass** die Regelvorrichtung (24) ein adaptives Filter ist, dessen Filterkoeffizienten zyklisch durch ein an einen Referenzeingang (27) angelegtes Referenzsignal (28) anpassbar sind, so dass das gefilterte zweite Ausgangssignal des zweiten Analog-Digital-Wandlers (13) dem Referenzsignal (28) in Phase und Amplitude entspricht; dass der erste Signalzweig zwischen dem ersten Analog-Digital-Wandler (12) und der Schaltvorrichtung (33) zum Zuführen eines Referenzsignals (28) eine Verbindung (28) zu der Regelvorrichtung (24) aufweist;
**dass** der erste Signalzweig zwischen dem ersten Analog-Digital-Wandler (12) und der Referenzverbindung (28) zu der Regelvorrichtung (24) eine Verzögerungsschaltung (30) aufweist, welche geeignet ist, das erste digitale Ausgangssignal (19) des ersten Analog-Digital-Wandlers (12) für eine Zeitdauer, die der Verarbeitungsdauer der Regelvorrichtung (24) entspricht, zu verzögern.

2. Vorrichtung nach Anspruch 1,
**dadurch gekennzeichnet,**
**dass** die Regelvorrichtung (24) so eingerichtet ist, dass sie, wenn die Schaltvorrichtung (33) den ersten Signalzweig mit dem Signalausgang (34) verbindet, die Amplituden adaptiv anpasst und dass sie, wenn die Schaltvorrichtung (33) den zweiten Signalzweig mit dem Signalausgang (34) verbindet, die Amplituden des zweiten digitalen Ausgangssignals (20) entsprechend der bei der vorherigen Schaltstellung zuletzt angepassten Amplituden regelt.

3. Vorrichtung nach Anspruch 1 oder 2,
**dadurch gekennzeichnet,**
**dass** die Anpassung der Filterkoeffizienten abschaltbar ist.

4. Vorrichtung nach einem der Ansprüche 1 bis 3,
**gekennzeichnet durch**,
eine Steuervorrichtung (39) mit einem Signaleingang zum Empfang eines Steuersignals (18), welches die Übersteuerung des ersten Analog-Digital-Wandlers (12) beschreibt, und mit einem Signalausgang zum Ausgeben eines Schaltsignals (40).

5. Vorrichtung nach Anspruch 4,
**dadurch gekennzeichnet,**
**dass** der Signalausgang der Steuervorrichtung (39) mit einem Steuereingang (37) der Schaltvorrichtung (33) verbunden ist.

6. Vorrichtung nach einem der Ansprüche 1 bis 5,
**dadurch gekennzeichnet,**
**dass** der Signalausgang der Steuervorrichtung (39) mit einem Steuereingang (38) der Regelvorrichtung (24) verbunden ist.

7. Vorrichtung nach einem der Ansprüche 4 bis 6,
**dadurch gekennzeichnet,**
**dass** das Schaltsignal (40) der Steuervorrichtung (39) nach jedem Empfang einer Steuersignalinformation (18), welche einem übersteuerten Analog-Digital-Wandler (12) entspricht, für eine eingestellte Mindestzeit ausgebbar ist.

8. Vorrichtung nach einem der Ansprüche 4 bis 7,
**dadurch gekennzeichnet,**
**dass** ein Steuerausgang (17) des ersten Analog-Digital-Wandlers (12) mit dem Steuereingang der Steuervorrichtung (39) verbunden ist oder ein Steuerausgang eines Komparators in dem ersten Signalzweig mit dem Steuereingang der Steuervorrichtung (39) verbunden ist.

9. Vorrichtung nach einem der Ansprüche 1 bis 8,
**dadurch gekennzeichnet,**
**dass** der erste und der zweite Analog-Digital-Wandler (12, 13) gleichen Typs sind und beide mit einer gemeinsamen Zeitbasissignalquelle verbunden sind.

10. Vorrichtung nach einem der Ansprüche 1 bis 9,
**dadurch gekennzeichnet,**
**dass** die Teilungsvorrichtung (5) das Signal in einen ersten Leistungsbruchteil und einen zweiten Leistungsbruchteil aufteilt.

11. Vorrichtung nach einem der Ansprüche 1 bis 10,
**dadurch gekennzeichnet,**
**dass** der erste und der zweite Signalzweig jeweils einen digitalen Dezimierer (21, 22) aufweisen.

12. Vorrichtung nach einem der Ansprüche 1 bis 11,
**dadurch gekennzeichnet,**
**dass** ein dritter Signalzweig im Verhältnis zum zweiten Signalzweig aufgebaut ist, wie der zweite Signalzweig zum ersten Signalzweig, wobei eine Regelvorrichtung (48) des dritten Signalzweigs zum adaptiven Anpassen zumindest der Amplituden eines dritten digitalen Ausgangssignals eines dritten Analog-Digital-Wandlers (46) an die Amplituden des ersten digitalen Ausgangssignals (19) des ersten Analog-Digital-Wandlers (12) geeignet ist.

13. Vorrichtung nach einem der Ansprüche 1 bis 12,
**dadurch gekennzeichnet,**
**dass** die Initialisierungswerte der Regelvorrichtung statisch oder mit Hilfe eines Kalibriervorgangs dynamisch vorausberechenbar sind.

## Claims

1. Apparatus for digitizing data, having:
- a division apparatus (5) for dividing an analog input signal (2, 4) into a first analog signal (8), which can be output to a first output (6) of a first signal path and which has a first signal portion, and a second analog signal (9), which can be output to a second output (7) of a second signal path with a second signal portion;
- a first analog-to-digital converter (12) connected to the first output (6) of the division apparatus (5) for digitizing the first analog signal (8);
- a second analog-to-digital converter (13) connected to the second output (7) of the division apparatus (5) for digitizing the second analog signal (9);
- a switching apparatus (33) for connecting the first signal path or the second signal path to a signal output (34);
- a regulatory apparatus (24) arranged between the second analog-to-digital converter (13) and the switching apparatus (33) for adaptively matching at least the amplitudes of the second digital output signal (20) from the second analog-to-digital converter (13) to the amplitudes of the first digital output signal (19) from the first analog-to-digital converter (12),
**characterized**
**in that** the regulatory apparatus (24) is an adaptive filter, the filter coefficients of which can be cyclically matched by means of a reference signal (28) applied to a reference input (27), with the result that the filtered second output signal from the second analog-to-digital converter (13) corresponds to the reference signal (28) in terms of phase and amplitude; in that the first signal path has a connection (28) to the regulatory apparatus (24) between the first analog-to-digital converter (12) and the switching apparatus (33) for the purpose of supplying a reference signal (28);
**in that** the first signal path has a delay circuit (30) between the first analog-to-digital converter (12) and the reference connection (28) to the regulatory apparatus (24), which delay circuit is suitable for delaying the first digital output signal (19) from the first analog-to-digital converter (12) for a period of time which corresponds to the processing period of the regulatory apparatus (24).

2. Apparatus according to Claim 1,
**characterized**
**in that** the regulatory apparatus (24) is set up such that, when the switching apparatus (33) connects the first signal path to the signal output (34), said regulatory apparatus adaptively matches the amplitudes and in that, when the switching apparatus (33) connects the second signal path to the signal output (34), said regulatory apparatus regulates the amplitudes of the second digital output signal (20) in line with the amplitudes which have been matched most recently in the previous switching position.

3. Apparatus according to Claim 1 or 2,
**characterized**
**in that** the matching of the filter coefficients can be switched off.

4. Apparatus according to one of Claims 1 to 3,
**characterized by**
a control apparatus (39) having a signal input for receiving a control signal (18) which describes the overdriving of the first analog-to-digital converter (12), and having a signal output for outputting a switching signal (40).

5. Apparatus according to Claim 4,
**characterized**
**in that** the signal output of the control apparatus (39) is connected to a control input (37) of the switching apparatus (33).

6. Apparatus according to one of Claims 1 to 5,
**characterized**
**in that** the signal output of the control apparatus (39) is connected to a control input (38) of the regulatory apparatus (24).

7. Apparatus according to one of Claims 4 to 6,
**characterized**
**in that** the switching signal (40) from the control apparatus (39) can be output for a set minimum time whenever a piece of control signal information (18) which corresponds to an overdriven analog-to-digital converter (12) has been received.

8. Apparatus according to one of Claims 4 to 7,
**characterized**
**in that**. a. control output (17) of the first analog-to-digital converter (12) is connected to the control input of the control apparatus (39), or a control output of a comparator in the first signal path is connected to the control input of the control apparatus (39).

9. Apparatus according to one of Claims 1 to 8,
**characterized**
**in that** the first and second analog-to-digital converters (12, 13) are of the same type, and both are connected to a common time base signal source.

10. Apparatus according to one of Claims 1 to 9,
**characterized**
**in that** the division apparatus (5) splits the signal into a first power fraction and a second power fraction.

11. Apparatus according to one of Claims 1 to 10,
**characterized**
**in that** the first and second signal paths each have a digital decimator (21, 22).

12. Apparatus according to one of Claims 1 to 11,
**characterized**
**in that** a third signal path is designed in proportion to the second signal path in the way in which the second signal path is designed in proportion to the first signal path, wherein a regulatory apparatus (48) in the third signal path is suitable for adaptively matching at least the amplitudes of a third digital output signal from a third analog-to-digital converter (46) to the amplitudes of the first digital output signal (19) from the first analog-to-digital converter (12).

13. Apparatus according to one of Claims 1 to 12,
**characterized**
**in that** the initialization values of the regulatory apparatus can be calculated in advance statically or, by means of a calibration process, dynamically.

## Revendications

1. Dispositif pour numériser des données :
- un dispositif de séparation (5) pour séparer un signal d'entrée analogique (2, 4) en un premier signal analogique (8) pouvant être délivré avec une première partie du signal à une première sortie (6) d'une première branche de signal et un second signal analogique (9) pouvant être délivré avec une seconde partie de signal à une seconde sortie (7) d'une seconde branche de signal ;
- un premier convertisseur analogique-numérique (12) relié à la première sortie (6) du dispositif de séparation (5) pour numériser le premier signal analogique (8) ;
un second convertisseur analogique-numérique (13) relié à une seconde sortie (7) du dispositif de séparation (5) pour numériser le second signal analogique (9) ;
- un dispositif de commutation (33) pour relier la première branche de signal ou la seconde branche d'un signal à une sortie de signal (34) ;
- un dispositif de réglage (24) disposé entre le second convertisseur analogique-numérique (13) et le dispositif de commutation (33) pour un réglage adaptatif au moins des amplitudes du second signal de sortie numérique (20) du second convertisseur analogique-numérique (13) aux amplitudes du premier signal de sortie numérique (19) du premier convertisseur analogique-numérique (12)
**caractérisé en ce que**
le dispositif de réglage (24) est un filtre adaptatif, dont les coefficients de filtre peuvent être adaptés de façon cyclique par un signal de référence (28) appliqué à une entrée de référence (27), de sorte que le second signal de sortie filtré du second convertisseur analogique-numérique (13) correspond en phase et en amplitude au signal de référence (28) ;
**en ce que** la première branche de signal présente entre le premier convertisseur analogique-numérique (12) et le dispositif de commutation (33) en vue de la délivrance d'un signal de référence (28) une liaison (28) au dispositif de réglage (24) ;
**en ce que** la première branche de signal présente entre le premier convertisseur analogique-numérique (12) et la liaison de référence (28) au dispositif de réglage (24) un circuit de retard (30), qui est approprié pour ralentir le premier signal de sortie numérique (19) du premier convertisseur analogique-numérique (12) d'une durée, qui correspond à la durée de traitement du dispositif de réglage (24).

2. Dispositif selon la revendication 1,
**caractérisé en ce que**
le dispositif de réglage (24) est réalisé de sorte que, lorsque le dispositif de commutation (33) relie la première branche de signal à la sortie de signal (34), il correspond de façon adaptative aux amplitudes et **en ce que**, lorsque le dispositif de commutation (33) relie la seconde branche de signal à la sortie de signal (34), il règle les amplitudes du second signal de sortie numérique (20) de manière correspondant aux amplitudes adaptées en dernier à la position de commutation précédente.

3. Dispositif selon la revendication 1 ou 2,
**caractérisé en ce que**
l'adaptation des coefficients de filtre peut être interrompue.

4. Dispositif selon l'une des revendications 1 à 3,
**caractérisé par**
un dispositif de commande (39) comportant une entrée de signal pour recevoir un signal de commande (18), qui décrit la surmodulation du premier convertisseur analogique-numérique (12), et comportant une sortie de signal pour délivrer un signal de commutation (40).

5. Dispositif selon la revendication 4,
**caractérisé en ce que**
la sortie d'un signal du dispositif de commande (39) est reliée à une entrée de commande (37) du dispositif de commutation (33).

6. Dispositif selon l'une des revendications 1 à 5,
**caractérisé en ce que**
la sortie de signal du dispositif de commande (39) est reliée à une entrée de commande (38) du dispositif de réglage (24).

7. Dispositif selon l'une des revendications 4 à 6,
**caractérisé en ce que**
le signal de commutation (40) du dispositif de commande (39) peut être délivré pour un temps minimal réglé après chaque réception d'une information de signal de commande (18), qui correspond à un convertisseur analogique-numérique surmodulé (12).

8. Dispositif selon l'une des revendications 4 à 7,
**caractérisé en ce que**
une sortie de commande (17) du premier convertisseur analogique-numérique (12) est reliée à l'entrée de commande du dispositif de commande (39) ou une sortie de commande d'un comparateur dans la première branche de signal est reliée à l'entrée de commande du dispositif de commande (39).

9. Dispositif selon l'une des revendications 1 à 8,
**caractérisé en ce que**
les premier et second convertisseurs analogiques-numériques (12, 13) sont du même type et les deux sont reliés à une source de signal de base de temps commune.

10. Dispositif selon l'une des revendications 1 à 9,
**caractérisé en ce que**
le dispositif de séparation (5) sépare le signal en une première fraction de puissance et une seconde fraction de puissance.

11. Dispositif selon l'une des revendications 1 à 10,
**caractérisé en ce que**
les première et seconde branches de signal présentent respectivement un décimeur numérique (21, 22).

12. Dispositif selon l'une des revendications 1 à 11,
**caractérisé en ce que**
une troisième branche de signal est réalisée en relation à la seconde branche de signal, comme la seconde branche de signal à la première branche de signal, dans lequel un dispositif de réglage (48) de la troisième branche de signal est approprié en vue de l'adaptation adaptative au moins des amplitudes d'un troisième signal de sortie numérique d'un troisième convertisseur analogique-numérique (46) aux amplitudes du premier signal de sortie numérique (19) du premier convertisseur analogique-numérique (12).

13. Dispositif selon l'une des revendications 1 à 12,
**caractérisé en ce que**
les valeurs d'initialisation du dispositif de réglage peuvent être calculées de façon anticipée statiquement ou dynamiquement à l'aide d'un procédé de calibrage.
